# EUROPÄISCHE PATENTSCHRIFT

(11) **EP 1 732 129 B1**
(45) Veröffentlichungstag und Bekanntmachung des Hinweises auf die Patenterteilung: **12.02.2014**
(21) Anmeldenummer: 06011125.9
(22) Anmeldetag: 30.05.2006
(51) Int. Cl.: H01L 23/34, C23C 14/24, C23C 14/30, C30B 23/06

(54) **Hochtemperatur-Verdampferzelle und Verfahren zur Verdampfung hochschmelzender Materialien**
High temperature evaporator cell and method of evaporating high-melting materials
Cellule d'évaporation à haute température et procédé d'evaporation des materiaux à point de fusion élévés

(30) Priorität: 06.06.2005 DE 102005025935
(43) Veröffentlichungstag der Anmeldung: 13.12.2006
(73) Patentinhaber: CreaTec Fischer & Co. GmbH, 74391 Erligheim (DE); Forschungsverbund Berlin e.V., 12489 Berlin (DE)
(72) Erfinder: Braun, Wolfgang, 13349 Berlin (DE); Fischer, Albrecht, 74369 Löchgau (DE)
(74) Vertreter: Hertz, Oliver

(56) Entgegenhaltungen:
- EP-A- 0 803 893
- DE-A1- 4 106 579
- JP-A- 2005 194 552
- US-A- 5 522 955

## Beschreibung

Die Erfindung betrifft eine Verdampferzelle mit den Merkmalen des Oberbegriffs von Anspruch 1, insbesondere eine Effusions-Verdampferzelle zur Überführung eines hochschmelzenden Verdampfungsguts in die Gasphase (Verdampfung, Sublimation), und ein Verfahren zur Verdampfung von hochschmelzendem Verdampfungsgut mit den Merkmalen des Oberbegriffs von Anspruch 18.

Die Verdampfung von Materialien zur Abscheidung dünner Schichten ist ein weit verbreitetes Verfahren, z. B. in der technischen Physik und in der Halbleitertechnik. Bei der Verwendung von Materialien, die erst bei extrem hohen Temperaturen (oberhalb von z. B. 2000°C) in die Gasphase übergehen, gibt es besondere Anforderungen an die Verdampfungstechnik. Erstens muss der Verdampfer ausreichend temperaturstabil sein, um das Verdampfungsgut auf die gewünschte Verdampfungstemperatur zu erwärmen. Zweitens wird durch die hohen Energieströme, die zur Erzielung der Verdampfungstemperatur erforderlich sind, häufig eine genaue und reproduzierbare Einstellung einer Verdampfungsrate erschwert. Schließlich besteht bei den hohen Temperaturen eine Tendenz zu Reaktionen des Verdampfungsguts, die beim reaktiven Verdampfen erwünscht sein können, in Bezug auf ggf. vorhandene Verunreinigungen jedoch vermieden werden müssen.

Besondere Herausforderungen bestehen bei der Herstellung von Dünnschicht-Bauelementen für die CMOS-Technik. Im Zuge der steigenden Integrationsdichte werden zunehmend hochschmelzende, keramische Materialien, z. B. Oxide der seltenen Erden zur Bildung von Isolatorschichten verwendet. Eine reaktive Verdampfung keramischer Materialien, bei der die gewünschte stöchiometrische Zusammensetzung in der Isolatorschicht durch einen Sauerstoffpartialdruck während der Verdampfung eingestellt wird, ist in der CMOS-Technik in der Regel ausgeschlossen, da durch den Sauerstoff auf freien Siliziumoberflächen des Dünnschichtbauelements unerwünschte Oxidschichten gebildet werden. Daher besteht ein Interesse an einer nichtreaktiven Dampfabscheidung, bei der das Verdampfungsgut bereits die gewünschte stöchiometrische Zusammensetzung der Isolatorschicht aufweist.

Aus der Praxis sind die folgenden Probleme bei der Verdampfung oder Sublimation stöchiometrischen Verdampfungsguts bekannt. Ein erstes Problem tritt auf, wenn das Verdampfungsgut in der Umgebungsatmosphäre instabil ist. Dies ist bspw. bei der Keramik Pr₂O₃ der Fall, die unter dem Einfluss von Wasserdampf in eine stöchiometrisch veränderte Oxidationsstufe zerfällt, die ihrerseits bei der Verdampfung unerwünschten Sauerstoff freisetzt. Der Verdampfer kann somit mit einem hochreinen Material, das in der Atmosphäre instabil ist, nur mit großem Aufwand beladen werden. Wenn dem Verdampfungsgut zur Beladung eine stabilisierende Zusatzsubstanz zugefügt wird, wäre vor der Verdampfung des Verdampfungsguts eine Reinigung zur Beseitigung der Zusatzsubstanz erforderlich, die jedoch mit der herkömmlichen Verdampfertechnik aus den folgenden Gründen ausgeschlossen ist.

Die zur Verdampfung hochschmelzender Materialien erforderlichen Temperaturen werden typischerweise mit Elektronenstrahlverdampfern erzeugt. Generell besteht bei der direkten Erwärmung des Verdampfungsguts durch einen Elektronenstrahl das Problem, das mit dem Elektronenstrahl nur die Oberfläche des Verdampfungsguts beheizt wird, so dass sich eine inhomogene Erwärmung des Verdampfungsguts ergibt. Wenn der Elektronenstrahl auf das Verdampfungsgut gerichtet wird, erfolgt eine starke lokale Oberflächenerwärmung bis hin zur Verdampfung, jedoch keine gleichmäßige Erwärmung des Verdampfungsguts. Daher ist ein Elektronenstrahlverdampfer zur Sublimationsreinigung des Verdampfungsguts nicht geeignet.

Ähnliche Probleme ergeben sich aus der Tatsache, dass die z. B. für die CMOS-Technik interessierenden Keramiken häufig als Granulate oder Pulver vorliegen, die eine sichere Beladung von Verdampfern erschweren. Insbesondere für großtechnische Anwendungen ist die Beladung des Verdampfers mit gesinterten Körpern des Verdampfungsguts erwünscht. Der Sinterprozess erfordert jedoch ebenfalls den Zusatz eines Bindemittels, das vor der Verdampfung durch eine Sublimationsreinigung entfernt werden müsste.

Es ist auch möglich, dem genannten Stabilitätsproblem zu begegnen, indem eine in der Atmosphäre stabile Oxidationsstufe des Verdampfungsguts in den Verdampfer geladen und vor der Verdampfung in die gewünschte stöchiometrische Oxidationsstufe durch eine Temperung umgewandelt wird. Beispielsweise ist die an Luft stabile Keramik Pr₆O₁₁ in hoher Reinheit verfügbar, erfordert jedoch zur Umwandlung in Pr₂O₃ eine Temperung. Mit herkömmlichen Elektronenstrahlverdampfern ist eine homogene Temperung wegen der lokalen Oberflächenerwärmung des Verdampfungsguts jedoch nicht möglich.

Allgemein ist festzustellen, dass sich mit einem herkömmlichen Elektronenstrahlverdampfer die Temperatur des Verdampfungsguts nicht ausreichend genau und reproduzierbar einstellen lässt, um eine bestimmte Reinigungs- oder Temperungswirkung zu erzielen oder eine bestimmte Verdampfungsrate einzustellen. Dieses Problem kann mit einer herkömmlichen thermischen Widerstandsheizung eines Tiegels mit einem Heizwiderstand und einer Temperaturkontrolle mit einem Thermoelement nicht gelöst werden, da in diesem Fall der Nachteil besteht, dass die herkömmlichen Widerstandsheizungs-Verdampfer lediglich für Temperaturen unterhalb von 1900°C ausgelegt sind.

Die genannten Probleme bei der Verdampfung hochschmelzender Materialien bestehen nicht nur in der CMOS-Halbleitertechnik, sondern auch bei anderen Verdampfüngsaufgaben für Beschichtungs- oder Reinigungszwecke.

Weitere Verdampfungseinrichtungen sind aus US 5 522 955, EP 0 803 893 A2 und DE 41 06 579 A1 bekannt.

Ein weiteres allgemeines Problem der herkömmlichen Verdampfungstechnik für hochschmelzende Materialien besteht darin, dass die Verdampfercharakteristik eines Elektronenstrahlverdampfers nur beschränkt ausreichend stabil einstellbar ist. Durch die inhomogene Oberflächenerwärmung des Verdampfungsguts kommt es zu einer irregulären Veränderung der Oberfläche des Verdampfungsguts während der Verdampfung und mit dieser zu einer Veränderung der Verdampfercharakteristik. Für Anwendungen in der Dünnschichttechnologie kommt es jedoch wesentlich darauf an, die Homogenität der Schichtabscheidung auf einem Substrat während des gesamten Beschichtungsvorgangs reproduzierbar steuern zu können. Aus diesem Grund besteht ein Interesse an der Verwendung von Effusionszellen zur Einstellung eines bestimmten Dampfstrahls des Verdampfungsguts. Effusionszellen für hochschmelzende Materialien insbesondere für großtechnische Zwecke sind jedoch bisher nicht verfügbar.

Die Aufgabe der Erfindung ist es, eine verbesserte Verdampferzelle zur Überführung hochschmelzender Materialien in die Gasphase, insbesondere eine verbesserte Effusionszelle bereitzustellen, mit der die Nachteile der herkömmlichen Verdampfungstechnik überwunden werden und die insbesondere eine genaue, reproduzierbare und zeitlich stabile Einstellung einer vorbestimmten Temperatur des Verdampfungsgutes ermög-licht. Die Verdampferzelle soll insbesondere für einen Betrieb oberhalb von 1900°C geeignet sein. Gemäß einem weiteren Gesichtspunkt soll die Verdampferzelle für einen stabilen, großtechnischen Einsatz zur Verdampfung größerer Mengen von Verdampfungsgut geeignet sein, als dies mit der herkömmlichen Technik möglich ist. Die Aufgabe der Erfindung besteht auch in der Bereitstellung eines verbesserten Verfahrens zur Verdampfung hochschmelzender Materialien, insbesondere bei Temperaturen oberhalb von 1900°C, mit dem die Probleme der herkömmlichen Techniken überwunden werden.

Diese Aufgaben werden durch eine Verdampferzelle und ein Verdampfungsverfahren mit den Merkmalen der Ansprüche 1 und 18 gelöst. Vorteilhafte Ausführungsformen und Anwendungen der Erfindung ergeben sich aus den abhängigen Ansprüchen.

Vorrichtungsbezogen basiert die Erfindung auf der allgemeinen technischen Lehre, bei einer Verdampferzelle mit einem Tiegel zur Aufnahme eines zu bearbeitenden Materials eine Kombination aus einer Widerstandsheizung und einer Elektronenstrahlheizung vorzusehen, mit denen die Temperatur des Tiegels einstellbar ist. Beide Heizungstypen wirken von außen auf den Tiegel. Es ist eine einzige Heizeinrichtung vorgesehen, die ein Bauteil zur Energieübertragung auf die Außenseite des Tiegels enthält, das sowohl zur Widerstandsheizung als auch zur Bestrahlung des Tiegels mit Elektronen eingerichtet ist. Die Erfinder haben festgestellt, dass ein Heizwiderstand zur an sich bekannten, indirekten Erwärmung des Tiegels als Elektronenemitter verwendbar ist. Die Elektronenemission kann in und oberhalb eines Temperaturbereiches erzeugt werden, in dem die Temperatur des Tiegels mit der Widerstandsheizung einstellbar ist. Vorteilhafterweise wird daher mit der erfindungsgemäßen Verdampferzelle ein stufenloser Übergang von der Widerstandsheizung zur Elektronenstrahlheizung ermöglicht.

Vorteilhafterweise kann somit die Temperatur des zu bearbeitenden Materials je nach den konkreten Anforderungen im gesamten Temperaturbereich eingestellt werden. Beispielsweise kann zunächst in einem niedrigeren Temperaturbereich eine Reinigung des Materials von leichter flüchtigen Komponenten und in einem höheren Temperaturbereich die Überführung des Materials in die Gasphase vorgesehen sein.

Ein besonderer Vorteil der Erfindung besteht darin, dass mit der kombinierten Widerstands- und Elektronenstrahlheizung die Temperatur des Tiegels unmittelbar einstellbar ist. Aufgrund der hohen Wärmeleitfähigkeit der in dem interessierenden Temperaturbereich verwendbaren Tiegelmaterialien, wie z. B. Wolfram oder Tantal, wird die in den Tiegel übertragene Wärmeenergie gleichmäßig auf das im Tiegel enthaltende Material übertragen. Im Gegensatz zur herkömmlichen Elektronenstrahlverdampfung wird nicht nur die Oberfläche des Materials geheizt, sondern eine homogene Erwärmung im Tiegel erreicht. Damit werden die folgenden vorteilhaften Wirkungen für die praktische Anwendung der Verdampferzelle erzielt. Erstens wird eine Temperatursteuerung ermöglicht. Die Temperatur kann mit erhöhter Genauigkeit in Abhängigkeit von der konkreten Anwendung und dem Material gewählt werden. Zweitens werden neue Anwendungsmöglichkeiten für die Verdampferzelle, wie z. B. zur Reinigung hochschmelzenden Materials eröffnet. Drittens kann in der Verdampferzelle das zu bearbeitende Material in die Gasphase überführt werden und mit einer vorbestimmten Charakteristik aus der Verdampferzelle austreten. Die Charakteristik wird durch die Geometrie der Verdampferzelle und nicht wie bei herkömmlichen Elektronenstrahlverdampfern durch zufällige Prozesse auf der Materialoberfläche bestimmt.

Die erfindungsgemäße Verdampferzelle stellt somit vorzugsweise eine Effusionszelle dar. Sie ist insbesondere zur genauen und reproduzierbaren Abscheidung von Schichten aus hochschmelzenden Materialien, z. B. in der Halbleitertechnik geeignet. Mit der Verdampferzelle werden Temperaturen oberhalb von 2500 °C, insbesondere bis 3000 °C erreicht. Die erfindungsgemäße Verdampferzelle weist einen erweiterten Anwendungsbereich auf. Sie kann bspw. zur Reinigung hochschmelzender Materialien und/oder zur Überführung hochschmelzender, ggf. gereinigter Materialien in die Gasphase verwendet werden.

Im Folgenden wird das zu bearbeitende Material unabhängig von der konkreten Aufgabe der Verdampferzelle und unabhängig von der Art des Phasenübergangs als Verdampfung oder Sublimation als "Verdampfungsgut" bezeichnet. Entsprechend wird der Übergang in die Gasphase im Folgenden unabhängig von der Tatsache, ob im konkreten Fall eine Verdampfung aus der Schmelze oder eine Sublimation aus dem Festzustand erfolgt, als "Verdampfung" bezeichnet.

Wenn sich der Heizwiderstand zur kombinierten Widerstandsheizung und Elektronenstrahlheizung gemäß einer bevorzugten Ausführungsform der Erfindung auf mehreren Seiten des Tiegels erstreckt, kann die Genauigkeit und Reproduzierbarkeit der Temperatureinstellung vorteilhafterweise verbessert werden. Der Tiegel umfasst typischerweise einen Tiegelboden und eine einen Innenraum des Tiegels umgebende Seitenwand. Die Verteilung des Heizwiderstandes auf mehreren Seiten des Tiegels bedeutet, dass der Heizwiderstand (oder Widerstandselemente) auf der Außenseite der Seitenwand verteilt angeordnet ist. Insbesondere zur Verdampfung größerer Mengen von Verdampfungsgut ist vorzugsweise vorgesehen, dass der Tiegel eine langgestreckte Form aufweist. Die charakteristische Größe (z. B. der Durchmesser) des Tiegelbodens ist geringer als die Ausdehnung (z. B. Höhe der Seitenwände). Bei dieser Ausführungsform der Erfindung erstreckt sich der Heizwiderstand vorzugsweise entlang der Längsausdehnung auf der Außenseite des Tiegels. Vorteilhafterweise kann damit die Temperatureinstellung des gesamten Verdampfungsgutes mit einer verkürzten Ansprechzeit erreicht werden.

Wenn gemäß einer besonders bevorzugten Variante der Tiegel die Form eines Zylinders, z. B. mit einer kreisförmigen oder elliptischen Grundfläche aufweist, ergibt sich vorteilhafterweise ein vereinfachter Aufbau der Verdampferzelle. Des Weiteren ist die Temperaturverteilung im Verdampfungsgut in allen Phasen eines Verdampfungsvorganges weitgehend konstant. Gemäß einer alternativen Variante weist der Tiegel die Form eines Konus auf, der sich vom Tiegelboden zur Tiegelöffnung aufweitet. Der konisch geformte Tiegel ist mit dem Vorteil verbunden, dass größere Flächen homogen bedampft werden können.

Gemäß einer besonders bevorzugten Ausführungsform der Erfindung ist die Verdampferzelle mit mindestens einer Temperaturmesseinrichtung ausgestattet, mit der eine Betriebstemperatur der Verdampferzelle erfassbar ist. Obwohl die Verwendung einer Temperaturmesseinrichtung von herkömmlichen Widerstandsheizungen an sich bekannt ist, stellt die Messung der Temperatur, die unmittelbar in der erfindungsgemäßen Verdampferzelle gegeben ist, einen erheblichen Fortschritt dar. Die Erfinder haben festgestellt, dass die Betriebstemperatur sowohl während der Widerstands- als auch während der Elektronenstahlheizung zuverlässig messbar ist. Eine Störung der Temperaturmessung während des Elektronenstrahlbetriebes konnte vermieden werden. Die homogene Tiegelheizung ermöglicht die zuverlässige Messung von Temperaturwerten und/oder die Überwachung eines vorbestimmten Zeitregimes der Temperatursteuerung bei einem Verdampfungsvorgang. Die Temperaturmesseinrichtung kann zur Temperaturmessung im oder unmittelbar am Tiegel, zum Beispiel an oder neben einer Wand des Tiegels eingerichtet sein. Für eine zuverlässige und störungsfreie Messung ist die Anordnung der Temperaturmesseinrichtung jedoch vorzugsweise in der Verdampferzelle mit einem Abstand von der Außenseite des Tiegels, z. B. unterhalb des Tiegelbodens vorgesehen. Alternativ kann die Temperaturmesseinrichtung für eine optische Temperaturmessung außerhalb der Verdampferzelle angeordnet sein.

Die Temperaturmessung kann mit verschiedenen Typen von Temperaturmesseinrichtungen, wie z. B. Strahlungsbolometern erfolgen. Für die optische Temperaturmessung ist vorzugsweise außerhalb der Verdampferzelle ein Strahlungsdetektor vorgesehen, mit dem ggf. durch ein Sichtfenster oder eine Öffnung in einer Abschirmeinrichtung eine von der Außen- oder Innenwand des Tiegels ausgehende, temperaturabhängige Wärmestrahlung erfassbar ist. Besonders bevorzugt ist jedoch ein Thermoelement vorgesehen. In dem interessierenden Bereich hoher Temperaturen sind Thermoelemente, insbesondere auf der Basis von Wolfram und Rhenium verfügbar (siehe z. B. R. R. Asamoto et al. in "The Review of Scientific Instruments", Bd. 38, 1967, S. 1047). Vorteilhafterweise hat ein Thermoelement des Weiteren einen geringen Platzbedarf, so dass eine Wärmeleitung nach außen minimiert und unerwünschte Störungen des Betriebs der Verdampferzelle vermieden werden können.

Gemäß einer weiteren bevorzugten Ausführungsform der Erfindung weist der Tiegel der Verdampferzelle eine Halteeinrichtung zur thermisch isolierten Positionierung des Tiegels relativ zu den anderen Teilen der Verdampferzelle und insbesondere relativ zu einem Träger auf. Die Halteeinrichtung stellt eine mechanische Halterung dar, welche die äußere Oberfläche des Tiegels im Wesentlichen freilässt, wenn dieser aus einem elektrisch leitfähigen Material gebildet ist. Vorzugsweise ist die Halteeinrichtung in diesem Fall am Tiegelboden vorgesehen, so dass die Seitenwände des Tiegels für die Wärmeübertragung von der Heizeinrichtung freiliegen. Wenn die Halteeinrichtung aus einem elektrisch leitfähigen Material besteht, kann sie vorteilhafterweise neben der mechanischen Halterung gleichzeitig als Hochspannungskontakt für den Tiegel dienen. Wenn der Tiegel aus einem elektrisch nicht leitfähigen Material besteht, ist die Halteeinrichtung so geformt, dass sie den größten Teil der Außenfläche des Tiegels überdeckt. In diesem Fall ist vorzugsweise eine formschlüssige Verbindung zwischen der Außenfläche des Tiegels und der Innenseite der Halteeinrichtung vorgesehen.

Wenn die Halteeinrichtung durch ein Bauteil mit einem Hohlprofil gebildet wird, können sich Vorteile für die Verminderung der Wärmeleitung vom Tiegel zur Umgebung und für eine stabile Positionierung des Tiegels auch bei extrem hohen Temperaturen ergeben. Die Halteeinrichtung ist bspw. ein Hohlzylinder oder ein Hohlkonus, der an der Unterseite des Tiegels angebracht ist. Die zylinder- oder konusförmige Halteeinrichtung weist eine besonders hohe mechanische Stabilität auf. Der Tiegel wird steif und vollflächig mit einem Schutz gegen Torsion und Verbiegung gehalten.

Vorteilhafterweise wird durch das Hohlprofil, das den Hochspannungskontakt des Tiegels bildet, in unmittelbarer Umgebung des Tiegels ein Raum geschaffen, in dem die Betriebstemperatur des Tiegels messbar ist und in dem eine reduzierte Feldstärke gegeben ist. Daher ist die Temperaturmesseinrichtung vorzugsweise zur Temperaturmessung im Inneren der Halteeinrichtung vorgesehen. Die Halteeinrichtung weist zum Beispiel eine seitliche Öffnung auf, durch welche die Temperaturmesseinrichtung, z. B. das Thermoelement in die Halteeinrichtung einführbar ist. Alternativ kann das Thermoelement axial vom Träger her von unten in die Halteeinrichtung einführbar sein. Die Positionierung des Thermoelements im Hohlprofil der Halteeinrichtung hat den besonderen Vorteil, dass eine allseitige Abschirmung des Thermoelements insbesondere gegen die hohen Feldstärken beim Betrieb der Heizeinrichtung als Elektronenstrahlheizung erreicht wird und unerwünschte Hochspannungsüberschläge vermieden werden.

Vorzugsweise ist an dem Träger eine Aufnahme vorgesehen, in welche die Halteeinrichtung einsteckbar ist. Die Aufnahme besitzt bspw. die Form eines zylinder- oder konusförmigen Schachtes, dessen Innenform an die Außenform des Hohlprofils der Halteeinrichtung angepasst ist. Vorteilhafterweise bildet die eingesteckte Halteeinrichtung einen festen mechanischen Kontakt mit dem Träger, so dass ein Verkippen des Tiegels während des Betriebes der Verdampferzelle vermieden wird.

Vorteilhafterweise ermöglicht die erfindungsgemäße Verdampferzelle eine genaue Temperatureinstellung im Tiegel. Hierzu ist vorzugsweise eine Regeleinrichtung vorgesehen, mit der die Heizeinrichtung einstellbar ist. Die Regeleinrichtung enthält mindestens einen, bevorzugt jedoch beide der folgenden Regelkreise. Ein erster Regelkreis dient der Einstellung eines Heizstroms des Heizwiderstandes für einen Widerstandsheizbetrieb. Der zweite Regelkreis dient der Einstellung eines Elektronenstroms vom Heizwiderstand zum Tiegel für einen Elektronenstrahl-Heizbetrieb. Beide Betriebsarten können in einem gemeinsamen Regelkreis realisiert werden, wobei die Bereitstellung der getrennten Regelkreise jedoch zur Vermeidung einer gegenseitigen Beeinflussung der Widerstands- und Elektronenstrahlheizungen bevorzugt ist.

In den Regelkreisen wird der Heiz- und/oder Elektronenstrom des Heizwiderstandes allgemein unter Verwendung einer Istgröße geregelt, die in Abhängigkeit von der konkreten Aufgabe der Verdampferzelle gewählt ist. Beispielsweise kann eine gemessene Aufdampfrate als Istgröße für die Regelkreise verwendet werden. Bevorzugt erfolgt die Regelung in Abhängigkeit von der Betriebstemperatur des Tiegels. Hierzu ist die Temperaturmesseinrichtung mit wenigstens einem der Regelkreise verbunden.

Eine Beschichtungsanlage, die mit mindestens einer erfindungsgemäßen Verdampferzelle ausgestattet ist, stellt einen unabhängigen Gegenstand der Erfindung dar. Vorteilhafterweise kann die Verdampferzelle in der Beschichtungsanlage mit einem relativ zur Vertikalen schräg ausgerichteten Tiegel angeordnet sein.

Verfahrensbezogen basiert die Erfindung auf der allgemeinen technischen Lehre, Verdampfungsgut in einem Tiegel einer Verdampferzelle einer indirekten Heizung zu unterziehen, wobei unter Verwendung eines Heizwiderstandes in einem ersten Temperaturbereich eine Widerstandsheizung und in einem zweiten Temperaturbereich eine Elektronenstrahlheizung des Tiegels vorgesehen ist. Vorzugsweise wird zur Überwachung des Betriebszustandes der Verdampferzelle und/oder zur Regelung der Betriebstemperatur in wenigstens einem der Temperaturbereiche die Betriebstemperatur der Verdampferzelle gemessen. Vorteilhafterweise können vorbestimmte Anteile der Widerstands- und Elektronenstrahlheizung zur Optimierung der Gesamtleistung in Abhängigkeit von der aktuellen Betriebstemperatur eingestellt werden.

Weitere Einzelheiten und Vorteile der Erfindung werden im Folgenden unter Bezugnahme auf die beigefügten Zeichnungen erläutert. Es zeigen:
- Figur 1:: eine schematische Schnittansicht einer ersten Ausführungsform der erfindungsgemäßen Verdampferzelle;
- Figur 2:: die erfindungsgemäße Kombination der Verdampferzelle mit einer Regeleinrichtung;
- Figur 3:: Kurvendarstellungen zur Illustration verschiedener Betriebszustände der erfindungsgemäßen Verdampferzelle; und
- Figuren 4A - 4C:: Einzelheiten einer weiteren Ausführungsform einer erfindungsgemäßen Verdampferzelle.

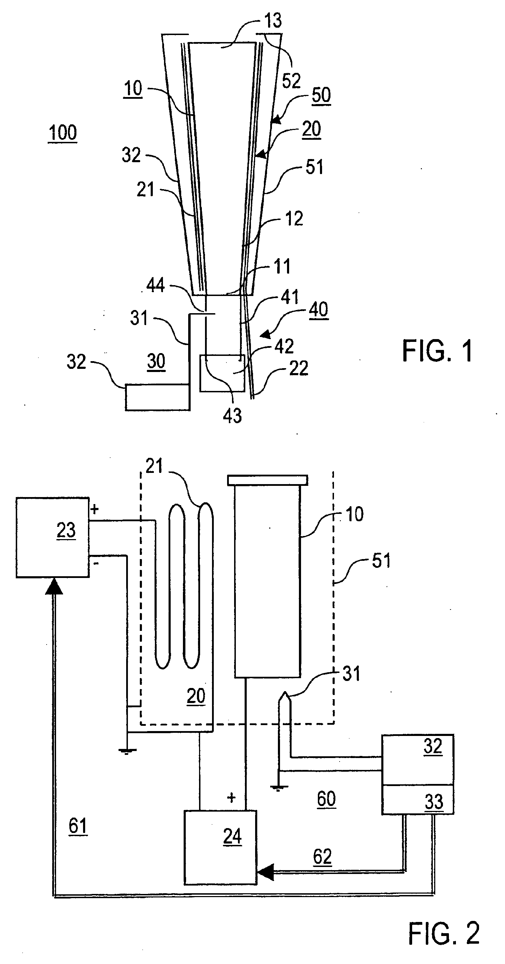

Die in Figur 1 in schematischer Schnittansicht gezeigte Verdampferzelle 100 umfasst einen Tiegel 10, eine Heizeinrichtung 20, eine Temperaturmesseinrichtung 30, eine Halteeinrichtung 40 und eine Abschirmeinrichtung 50.

Der Tiegel 10 zur Aufnahme von Verdampfungsgut mit einem Tiegelboden 11, einer umlaufenden Seitenwand 12 und einer Austrittsöffnung 13 weist eine Konusform mit einem sich vom Tiegelboden 11 zur Austrittsöffnung 13 vergrößernden Durchmesser auf. Der Tiegel 10 besteht aus einem ein- oder mehrlagigen Material, das bis zu einer Temperatur von 3400°C formbeständig und mechanisch stabil ist. Der Tiegel 10 kann vollständig aus einem Metallblech oder aus einer Zusammensetzung mit einem nicht-elektrisch leitfähigen Grundkörper und einer metallischen Beschichtung bestehen, wobei zum Verdampferbetrieb der elektrisch leitfähige Teil des Tiegels 10 jeweils mit einer Hochspannungsquelle 24 (siehe Figur 2) verbunden ist. Der Tiegel 10 besteht bspw. komplett aus Tantal oder aus einer Tantal-Wolfram-Kombination oder einer Wolfram-Rhenium-Legierung. Die Wolfram-Tantal-Kombination umfasst bspw. einen Aufbau mit dem Tiegelboden 11 aus Wolfram und der Seitenwand 12 aus Tantal oder einen zweilagigen Aufbau mit einem inneren Wolfram-Konus und einem äußeren Tantal-Konus. Die letztere Variante hat den Vorteil, dass das äußere Tantalblech den inneren Wolframkonus mechanisch stabilisiert. Die Maße des Tiegels 10 betragen für ein Innenvolumen von rd. 10 cm³ z. B.: Durchmesser des Tiegelbodens: 1 cm, axiale Länge des Tiegels 10: rd. 10 bis 15 cm, Durchmesser der Austrittsöffnung 13: rd. 1.5 cm.

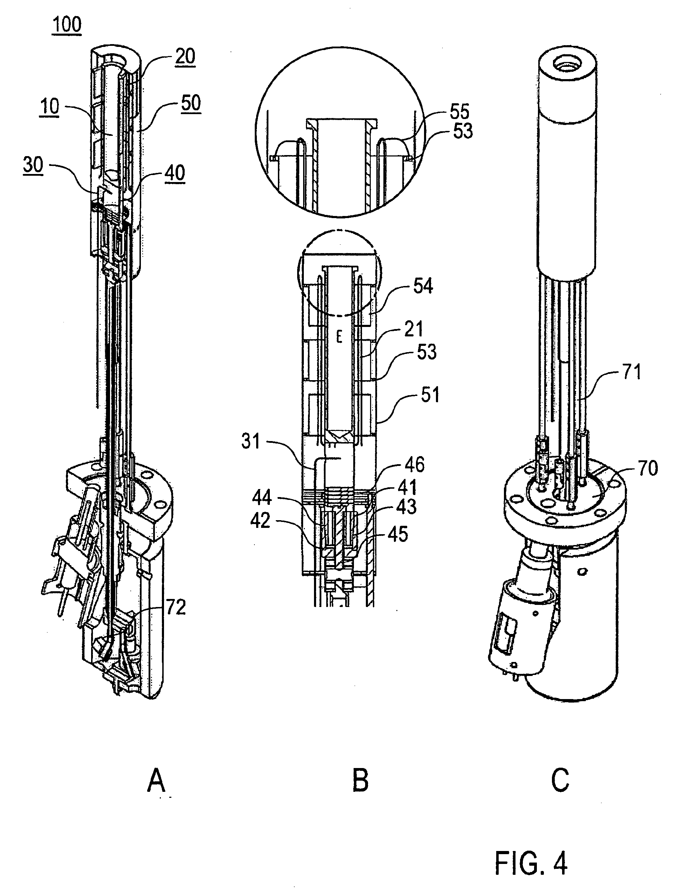

Die Heizeinrichtung 20 umfasst einen Heizwiderstand 21 und eine Anschlussleitung 22, die mit der Heizstromquelle 23 (siehe Figur 2) verbunden ist. Der Heizwiderstand 21 ist ein Widerstandsdraht aus einem für Widerstandsheizungen an sich gebräuchlichen Material, wie z. B. Wolfram oder Tantal mit einem Durchmesser von z. B. 0.635 mm. Der Heizwiderstand ist auf der Außenseite der Seitenwand 12 mit einem Abstand von deren Oberfläche angeordnet. Er bildet eine Heizwendel mit z. B. 12 paarweise entgegengesetzt ausgerichteten Leitungen. Die Bereitstellung der gepaarten Leitungen vermindert vorteilhafterweise unerwünschte Magnetfelder bei der Beaufschlagung des Heizwiderstands 21 mit einem Betriebsstrom. Der Heizwiderstand 21 ist mechanisch auf der Innenseite der Abschirmeinrichtung 50 gehaltert, wie dies mit weiteren Einzelheiten in Figur 4 gezeigt ist. Der Durchmesser der Heizeinrichtung 20 beträgt z. B. 20 mm.

Die Temperaturmesseinrichtung 30 umfasst ein Thermoelement 31, dessen Kontaktstelle unterhalb des Tiegelbodens 11 angeordnet und mit einem Messwandler 32 verbunden ist. Das Thermoelement ist bspw. ein Wolfram-Rhenium-Thermoelement, wie es in der o. g. Publikation von R. R. Asamoto et al. beschrieben ist. Der Messwandler 32 ist bspw. vom Typ "Eurotherm 2604".

Die Halteeinrichtung 40 umfasst einen Hohlzylinder 41 aus einem temperaturbeständigen Material, z. B. Tantal mit einer seitlichen Öffnung 44. Durch die Öffnung 44 kann das Thermoelement 31 in das Innere des Hohlzylinders 41 eingeführt werden. Der untere Rand des Hohlzylinders 41 ist mit einem Träger 42 verbunden, der ortsfest oder verstellbar in einer Beschichtungsanlage angeordnet ist. Der Träger 42 enthält eine ringförmige Aufnahme 43, in welcher der untere Rand des Hohlzylinders 41 befestigt ist. Die Halteeinrichtung 40 dient der stabilen Halterung und als elektrischer Hochspannungskontakt des Tiegels 10. Gemäß einer abgewandelten Variante der Erfindung kann das Thermoelement elektrisch isoliert durch den Träger 42 in den Hohlzylinder 41 ragen.

Die Halteeinrichtung 40 stellt eine thermische Isolation zwischen dem Tiegel 10 und den übrigen Teilen an der Beschichtungsanlage dar. Zur Minimierung der Wärmeleitung besteht der Hohlzylinder 41 aus einem Blech mit einer Dicke unterhalb von 200 µm, vorzugsweise kleiner als 500 µm, z. B. im Bereich von 50 µm bis 200 µm.

Die Abschirmeinrichtung 50 umfasst eine seitlich umlaufende Abschirmwand 51 und eine Abschirmkappe 52. Die Abschirmwand 51 stellt eine thermische Barriere nach außen und eine mechanische Halterung für den Heizwiderstand 21 der Heizeinrichtung dar. Sie besteht z. B. aus Ta-Blech mit einer Dicke von 50 µm oder mehreren Lagen einer Ta-Folie. Die Abschirmkappe 52 dient der thermischen Isolation zwischen der Verdampferzelle 100 und einem zu beschichtenden Substrat. Mit der Abschirmkappe 52 wird der Spalt zwischen dem Tiegel 10 und der Abschirmwand 51, in dem der Heizwiderstand 23 angeordnet ist, hin zum Substrat abgeschirmt. In der Mitte der Abschirmkappe 52 ist eine Öffnung vorgesehen, die den Dampfstrahl aus dem Tiegel 10 zum Substrat durchlässt. Die Öffnung wird je nach Anwendung möglichst klein gewählt (z. B. 15 mm), um die Homogenität der Temperaturverteilung im Tiegel 10 zu verbessern und die erforderliche Heizleistung zu minimieren.

Die Heizeinrichtung 20 ist elektrisch isoliert auf der Innenseite der Abschirmeinrichtung 50 befestigt (siehe Figur 4). Die Abschirmeinrichtung 50 ist an einem elektrisch isolierenden Teil des Trägers 42 oder einem anderen ortsfesten Teil einer Beschichtungsanlage (nicht dargestellt) befestigt. Die Abschirmeinrichtung 50 kann zusätzlich einen äußeren Kühlschild (nicht dargestellt) aufweisen, der z. B. einen mit flüssigem Stickstoff oder Wasser gekühlten Doppelmantel umfasst.

Die Einstellung des Betriebsstroms der Heizeinrichtung 20 erfolgt mit einer Regeleinrichtung 60, deren Teile schematisch in Figur 2 gezeigt sind. Der Heizwiderstand 21 auf der Außenseite des Tiegels 10 ist mit der Heizstromquelle 23 verbunden. Die Heizstromquelle 23 ist ein regelbares Netzteil für einen Heizstrom bis zu 25 A bei einer Ausgangs-Gleichspannung bis 40 V. Der eine Anschluss der Heizstromquelle 23 ist mit einem Ende des Heizwiderstandes 21 verbunden, während der andere Anschluss der Heizstromquelle 23 gemeinsam mit dem anderen Ende des Heizwiderstandes 21, der Abschirmwand 51, dem negativen Anschluss der Hochspannungsquelle 24 und einem Anschluss des Thermoelements 31 mit Massepotential verbunden ist. Die Erdung des Thermoelements 31 ist optional vorgesehen. Alternativ können der Messwandler 32 und der Regler 33 auf Tiegelpotential liegen.

Die Hochspannungsquelle 24 ist ein regelbares Gleichspannungs-Netzteil mit einem Ausgangsstrom bis zu 10 A und einer Ausgangsspannung bis zu 500 V. Der positive Anschluss der Hochspannungsquelle 24 ist über die Halteeinrichtung 40 (siehe Figur 1) mit dem Tiegel 10 verbunden, der beim Elektronenstrahlbetrieb der Heizeinrichtung 20 die Anode repräsentiert, auf die Elektronen vom Heizwiderstand 21 beschleunigt werden. Gemäß abgewandelten Varianten der Erfindung kann die Hochspannungsquelle für niedrigere (zum Beispiel rd. 300 V bis zu rd. 50 V) oder höhere Spannungen (zum Beispiel bis zu rd. 5000 V) ausgelegt sein. In der Praxis werden geringere Spannungen bei entsprechend möglichst hohen Strömen bevorzugt, um unbeabsichtigte elektrische Überschläge zu vermeiden.

Der Messwandler 32 des Thermoelements 31 ist mit einem Regler 33 (zum Beispiel einem PID-Regler) mit zwei Ausgängen verbunden. Von den Ausgängen des Reglers 33 werden Stellsignale an die Heizstromquelle 23 und die Hochspannungsquelle 24 geliefert.

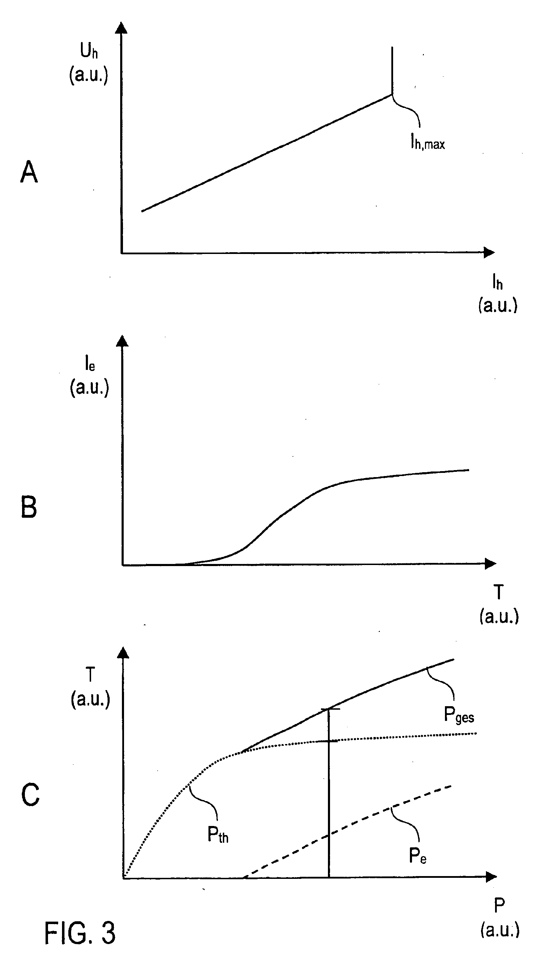

Die Regeleinrichtung 60 umfasst zwei Regelkreise. Im ersten Regelkreis 61 wird der Heizstrom der Heizstromquelle 23 durch den Heizwiderstand 21 in Abhängigkeit von der Betriebstemperatur des Tiegels 10 geregelt. Im zweiten Regelkreis 62 wird der Elektronenstrom vom Heizwiderstand 21 zum Tiegel 10 ebenfalls in Abhängigkeit von der Betriebstemperatur des Tiegels 10 geregelt. Bei der Temperatureinstellung werden bspw. die in den Figuren 3A bis 3C gezeigten Kennlinien realisiert. In einer ersten Betriebsphase erfolgt zunächst eine Beäufschlagung des Heizwiderstandes 21 mit dem Heizstrom Iₕ. Die Heizstromquelle 23 wird mit einer Strombegrenzung betrieben. Im Widerstandsheizbetrieb wird oberhalb eines vorbestimmten Maximalstromes I_{h,max} von z. B. 12.5 A (und einer Spannung von 26 V) die Heizleistung und damit die Temperatur des Tiegels 10 ausschließlich über die Heizspannung Uₕ geregelt, wie dies in Figur 3A dargestellt ist.

Wenn durch die Widerstandsheizung eine ausreichend hohe Temperatur von z. B. 1500°C erreicht wurde, wird in einer weiteren Betriebsphase die Elektronenstrahlheizung eingeschaltet. Die Elektronenemission vom Heizwiderstand 21 zum Tiegel 10 setzt bspw. bereits bei einer Hochspannung von 300 V ein. Mit dem steigenden Elektronenstrom Iₑ steigt auch die Temperatur des Tiegels 10, wie schematisch in Figur 3B gezeigt ist. Mit einer Steigerung des Elektronenstroms auf z. B. 800 mA wird eine Temperatur von 2700°C erreicht.

Um einen möglichst fließenden Übergang der Temperatureinstellung beim Wechsel von der Widerstands- zur Elektronenstrahlheizung zu erreichen, wird die Hochspannung der Hochspannungsquelle 24 bereits während der ersten Betriebsphase der Widerstandsheizung an den Tiegel 10 angelegt. Mit dem ersten Ausgang der Regeleinrichtung 33 wird gemäß Figur 3C die Temperatur T im Tiegel zunächst die thermische Heizung (gepunktet, Leistung Pₜₕ) erhöht, bis eine Temperatur erreicht ist, bei der die Elektronenemission vom Heizwiderstand 21 einsetzt. Die Heizung wird durch die Elektronenstrahl-Heizung (gestrichelt, Leistung Pₑ) überlagert. Beide Anteile addieren sich zur Leistung P_{ges} (durchgezogen gezeichnet). Zur weiteren Temperaturerhöhung wird die Leistung Pₜₕ der Widerstandsheizung nicht erhöht, sondern die Elektronenstrahlheizung verwendet.

Die senkrechte Linie in Figur 3C illustriert, dass die Anteile der Leistung durch die Widerstandsheizung und die Elektronenstrahlheizung erfindungsgemäß in vorbestimmter Weise einstellbar und optimierbar sind. In Abhängigkeit von der konkreten Anwendung der Verdampferzelle kann es z. B. von Vorteil sein, die Widerstandsheizung bei einer kleineren Leistung zu begrenzen und die Elektronenstrahlheizung entsprechend zu verstärken.

Weitere Einzelheiten einer weiteren Ausführungsform der Verdampferzelle 100 sind in den Figuren 4A (perspektivische Schnittansicht), 4B (vergrößerte Teilansicht) und 4C (Perspektivansicht) dargestellt. Der wesentliche Unterschied zwischen den Ausführungsformen der Figuren 1 und 4 besteht in der geometrischen Form des Tiegels 10. Im Übrigen können die in Figur 4 gezeigten Einzelheiten auch bei der in Figur 1 gezeigten Ausführungsform der Erfindung realisiert sein.

Die Figuren 4A und 4B zeigen den Tiegel 10, die Heizeinrichtung 20, den Temperatursensor 30, die Halteeinrichtung 40 und die Abschirmeinrichtung 50. Der Tiegel 10 ist ein gerader Hohlzylinder aus Wolframblech. Die Abschirmwand 51 besteht aus mehreren Lagen einer Tantalfolie. Die Heizdrähte des Heizwiderstandes 21 erstrecken sich über die gesamte Länge des Tiegels 10. Vorteilhafterweise erfolgt bei der Elektronenstrahlheizung die Elektronenemission ebenfalls entlang der gesamten Länge des Heizwiderstandes 10. Die mechanische Halterung des Heizwiderstandes 10 ist mit weiteren Einzelheiten in Figur 4B gezeigt. Auf der Innenseite der Abschirmwand 51 sind mit Isolationsringen 53 ringförmige Metallschilde 54 angebracht. Zwischen den Metallschilden 54 sind Lücken, durch die Bindedrähte 55 (siehe vergrößertes Teilbild in Figur 4B) zur Fixierung des Heizwiderstands 21 an den Isolationsringen 53 geführt sind. Durch die Bindedrähte 55 (z. B. aus Tantal) wird der Heizwiderstand 21 elektrisch isoliert von allen anderen Teilen, insbesondere elektrisch isoliert vom Tiegel 10 und von den Metallschilden 54 gehaltert.

Der Hohlzylinder 41 der Halteeinrichtung 40 verjüngt sich an seinem unteren Ende konusförmig. Die konusförmige Verjüngung steckt in einer ebenfalls konusförmigen Aufnahme 43 des Trägers 42. Die Fixierung des Hohlzylinders 41 in der Halterung 43 erfolgt mit einem ebenfalls konusförmigen Innenstück 44, das mit einer Spannschraube 45 in die Aufnahme 43 des Trägers 42 gezogen werden kann. Gemäß einer alternativen Variante kann die Spannschraube 45 innen hohl sein, um das Thermoelement axial in den Innenraum des Hohlzylinders 41 durchzuführen. Das Thermoelement 31 ist bei der illustrierten Ausführungsform durch die seitliche Öffnung des Hohlzylinders 41 geführt. Auf der Oberseite des Trägers 42 sind mehrere Lagen eines Tantalbleches 46 angeordnet, um die thermische Isolation zwischen dem Tiegel 10 und dem Träger 42 zu verbessern.

Der Träger 42 ist mit einem Sockel 70 über starre Rohrleitungen 71 verbunden, in denen die Anschlussleitungen des Heizwiderstandes, die Hochspannungsleitung des Tiegels und die Leitungen des Thermoelements angeordnet sind. Die Rohrleitungen 71 dienen des Weiteren einer Kühlung der Anschlussleitungen mit Kühlwasser, das über Kühlwasseranschlüsse 72 (siehe Figur 4A) zugeführt wird. Der Sockel 70 weist einen Vakuumflansch (z. B. mit der Größe CF 40) auf, der an einer Beschichtungsanlage montierbar ist.

Die in der vorstehenden Beschreibung, den Zeichnungen und den Ansprüchen offenbarten Merkmale der Erfindung können sowohl einzeln als auch in Kombination für die Verwirklichung der Erfindung in ihren verschiedenen Ausgestaltungen von Bedeutung sein.

## Patentansprüche

1. Verdampferzelle (100), die zur Verdampfung eines hochschmelzenden Verdampfungsguts bei einer Temperatur oberhalb von 1900 °C eingerichtet ist und die umfasst:
- einen Tiegel (10) zur Aufnahme des Verdampfungsguts, und
- eine Heizeinrichtung (20) mit einem Heizwiderstand (21) zur Widerstandsheizung des Tiegels (10),
**dadurch gekennzeichnet, dass**
- der Heizwiderstand (21) zur mehrseitigen Erwärmung des Tiegels (10) angeordnet ist,
- der Heizwiderstand (21) als ein Elektronenemitter zur Elektronenstrahlheizung des Tiegels (10) vorgesehen und zur Bestrahlung der Außenseite des Tiegels mit Elektronen angeordnet ist.

2. Verdampferzelle nach Anspruch 1, bei welcher der Tiegel eine Längsausdehnung aufweist und der Heizwiderstand (21) entlang der Längsausdehnung auf der Außenseite des Tiegels (10) angeordnet ist.

3. Verdampferzelle nach Anspruch 2, bei welcher der Tiegel (10) eine Zylinderform oder eine Konusform aufweist.

4. Verdampferzelle nach mindestens einem der vorhergehenden Ansprüche, bei welcher eine Temperaturmesseinrichtung (30) vorgesehen ist, mit der eine Betriebstemperatur der Verdampferzelle (100) messbar ist.

5. Verdampferzelle nach Anspruch 4, bei welcher die Temperaturmesseinrichtung (30) ein Thermoelement (31) umfasst.

6. Verdampferzelle nach Anspruch 5, bei der mit dem Thermoelement (31) die Betriebstemperatur der Verdampferzelle in der Umgebung eines Tiegelbodens (11) des Tiegels (10) messbar ist.

7. Verdampferzelle nach mindestens einem der vorhergehenden Ansprüche, bei welcher der Tiegel (10) über eine thermisch isolierende Halteeinrichtung (40) mit einem Träger (42) verbunden ist.

8. Verdampferzelle nach Anspruch 7, bei der die Halteeinrichtung (40) ein Hohlprofil (41) aufweist, das am Tiegelboden (11) des Tiegels (10) angebracht ist.

9. Verdampferzelle nach Anspruch 8, bei der das Thermoelement (31) in dem Hohlprofil (41) angeordnet ist.

10. Verdampferzelle nach Anspruch 8 oder 9, bei der das Hohlprofil (41) in eine Aufnahme (43) des Trägers (42) einsteckbar ist.

11. Verdampferzelle nach mindestens einem der vorhergehenden Ansprüche, bei welcher eine Regeleinrichtung (60) zur Einstellung der Heizeinrichtung (20) vorgesehen ist.

12. Verdampferzelle nach Anspruch 11, bei der die Regeleinrichtung (60) einen ersten Regelkreis (61) zur Einstellung eines Widerstands-Heizbetriebes enthält.

13. Verdampferzelle nach Anspruch 11 oder 12, bei der die Regeleinrichtung (60) einen zweiten Regelkreis (62) zur Einstellung eines Elektronenstrahl-Heizbetriebes enthält.

14. Verdampferzelle nach mindestens einem der Ansprüche 11 bis 13, bei welcher die Regeleinrichtung (60) zur gleichzeitigen Einstellung des Widerstands-Heizbetriebes und des Elektronenstrahl-Heizbetriebes vorgesehen ist.

15. Verdampferzelle nach mindestens einem der Ansprüche 11 bis 14, bei welcher die Temperaturmesseinrichtung (30) mit wenigstens einem der ersten und zweiten Regelkreise (61, 62) verbunden ist.

16. Beschichtungsanlage, die mit mindestens einer Verdampferzelle nach mindestens einem der vorhergehenden Ansprüche ausgestattet ist.

17. Verfahren zur Verdampfung eines hochschmelzenden Verdampfungsguts bei einer Temperatur oberhalb von 1900 °C, mit den Schritten:
- Bereitstellung des Verdampfungsguts in einem Tiegel (10), und
- Heizung des Tiegels (10), bei der in einem ersten Temperaturbereich eine Widerstandsheizung des Tiegels (10) mit einem Heizwiderstand (21) einer Heizeinrichtung (20) erfolgt,
**dadurch gekennzeichnet, dass**
- bei der Heizung des Tiegels (10) in einem zweiten Temperaturbereich eine Elektronenstrahlheizung des Tiegels (10) mit dem Heizwiderstand (21) erfolgt.

18. Verfahren nach Anspruch 17, bei dem die Erwärmung auf mehreren Seiten des Tiegels (10) vorgesehen ist.

19. Verfahren nach Anspruch 17 oder 18, bei dem eine Betriebstemperatur der Verdampferzelle (100) gemessen wird.

20. Verfahren nach Anspruch 19, bei dem die Betriebstemperatur der Verdampferzelle (100) in der Umgebung eines Tiegelbodens (11) des Tiegels (10) gemessen wird.

21. Verfahren nach mindestens einem der Ansprüche 17 bis 20, mit dem weiteren Schritt:
- Einstellung der Heizeinrichtung (20) mit einer Regeleinrichtung (60).

22. Verfahren nach Anspruch 21, bei dem in der ersten Betriebsphase ein Widerstands-Heizbetrieb mit einem ersten Regelkreis (61) vorgesehen ist.

23. Verfahren nach Anspruch 21 oder 22, bei dem in der zweiten Betriebsphase ein Elektronenstrahl-Heizbetrieb mit einem zweiten Regelkreis (62) vorgesehen ist.

24. Verfahren nach Anspruch 22 oder 23, bei dem ein Temperatursignal des Temperatursensor wenigstens einem der ersten und zweiten Regelkreise (61, 62) als Regelgröße zugeführt wird.

## Claims

1. Evaporator cell (100), being adapted for evaporating a high-melting material to be evaporated at a temperature above 1900 °C and comprising:
- a crucible (10) for receiving the material to be evaporated, and
- a heating device (20) with a heating resistor (21) for resistance heating of the crucible (10),
**characterized in that**
- the heating resistor (21) is provided for a multi-sided heating of the crucible (10),
- the heating resistor (21) is provided as an electron emitter for electron beam heating of the crucible (10) and is arranged for irradiating of the outer side of the crucible with electrons.

2. Evaporator cell according to claim 1, in which the crucible has a longitudinal extension and the heating resistor (21) is arranged along the longitudinal extension on the outer side of the crucible (10).

3. Evaporator cell according to claim 2, in which the crucible (10) has a cylindrical or a conical form.

4. Evaporator cell according to at least one of the foregoing claims, in which a temperature measuring device (30) is provided with which an operating temperature of the evaporator cell (100) can be measured.

5. Evaporator cell according to claim 4, in which the temperature measuring device (30) comprises a thermocouple (31).

6. Evaporator cell according to claim 5, in which the operating temperature of the evaporator cell can be measured in the environment of a crucible bottom (11) of the crucible (10) with the thermocouple (31).

7. Evaporator cell according to at least one of the foregoing claims, in which the crucible (10) is connected via a thermally insulating holding device (40) to a carrier (42).

8. Evaporator cell according to claim 7, in which the holding device (40) has a hollow profile (41) attached to the crucible bottom (11) of the crucible (10).

9. Evaporator cell according to claim 9, in which the thermocouple (31) is arranged in the hollow profile (41).

10. Evaporator cell according to claim 8 or 9, in which the hollow profile (41) can be inserted into a receptacle (43) of the carrier (42).

11. Evaporator cell according to at least one of the foregoing claims, in which a control device (60) is provided for adjusting the heating device (20).

12. The evaporator cell according to claim 11, in which the control device (60) includes a first control circuit (61) for adjusting a resistance heating operation.

13. The evaporator cell according to claim 11 or 12, in which the control device (60) includes a second control circuit (62) for adjusting an electron beam heating operation.

14. The evaporator cell according to at least one of the claims 11 to 13, in which the control device (60) is provided for simultaneously adjusting the resistance heating operation and the electron beam heating operation.

15. Evaporator cell according to at least one of the claims 11 to 14, in which the temperature measuring device (30) is connected with at least one of the first and the second control circuits (61, 62).

16. Coating installation, which is provided with at least one evaporator cell in accordance with at least one of the foregoing claims.

17. Method for evaporating a high-melting material to be evaporated at a temperature above 1900 °C, with the steps:
- providing the material to be evaporated in a crucible (10), and
- heating the crucible (10), in which a resistance heating of the crucible (10) is provided with a heating resistor (21) of a heating device (20) in a first temperature range,
**characterized in that**
- an electron beam heating of the crucible (10) is provided with the heating resistor (21) during the heating of the crucible (10) in a second temperature range.

18. Method according to claim 17, in which the heating is provided on several sides of the crucible (10).

19. Method according to claim 17 or 18, in which an operating temperature of the evaporator cell (100) is measured.

20. Method according to claim 19, in which the operating temperature of the evaporator cell (100) is measured in the environment of a crucible bottom (11) of the crucible (10).

21. Method according to at least one of the claims 17 to 20, with the further step:
- adjusting the heating device (20) with a control device (60).

22. Method according to claim 21, in which a resistance heating operation with a first control circuit (61) is provided in the first operating phase.

23. Method according to claim 21 or 22, in which an electron beam heating operation with a second control circuit (62) is provided in the second operating phase.

24. Method according to claim 22 or 23, in which a temperature signal of the temperature sensor is supplied at least to one of the first and second control circuits (61, 62) as control variable.

## Revendications

1. Cellule d'évaporation (100), qui est configurée aux fins de l'évaporation d'un produit à évaporer présentant un point de fusion élevé à une température supérieure à 1900 °C et qui comprend :
- un creuset (10) servant à recevoir le produit à évaporer, et
- un dispositif de chauffage (20) pourvu d'une résistance chauffante (21) servant au chauffage par résistance du creuset (10),
**caractérisée en ce que**
- la résistance chauffante (21) est mise en place aux fins de la montée en température de plusieurs côtés du creuset (10),
- la résistance chauffante (21) est prévue comme un émetteur d'électrons servant au chauffage par faisceau électronique du creuset (10) et est mise en place afin d'exposer le côté extérieur du creuset à une radiation avec des électrons.

2. Cellule d'évaporation selon la revendication 1, dans le cadre de laquelle le creuset présente une extension longitudinale et la résistance chauffante (21) est mise en place le long de l'extension longitudinale sur le côté extérieur du creuset (10).

3. Cellule d'évaporation selon la revendication 2, dans le cadre de laquelle le creuset (10) présente une forme cylindrique ou une forme conique.

4. Cellule d'évaporation selon au moins l'une quelconque des revendications précédentes, dans le cadre de laquelle un dispositif de mesure de température (30) est prévu, lequel permet de mesurer une température de fonctionnement de la cellule d'évaporation (100).

5. Cellule d'évaporation selon la revendication 4, dans le cadre de laquelle le dispositif de mesure de température (30) comprend un thermocouple (31).

6. Cellule d'évaporation selon la revendication 5, dans le cadre de laquelle le thermocouple (31) permet de mesurer la température de fonctionnement de la cellule d'évaporation dans l'environnement d'un fond de creuset (11) du creuset (10).

7. Cellule d'évaporation selon au moins l'une quelconque des revendications précédentes, dans le cadre de laquelle le creuset (10) est relié, par l'intermédiaire d'un dispositif de maintien (40) assurant une isolation thermique, à un support (42).

8. Cellule d'évaporation selon la revendication 7, dans le cadre de laquelle le dispositif de maintien (40) présente un profilé creux (41), qui est placé au niveau du fond de creuset (11) du creuset (10).

9. Cellule d'évaporation selon la revendication 8, dans le cadre de laquelle le thermocouple (31) est mis en place dans le profilé creux (41).

10. Cellule d'évaporation selon la revendication 8 ou 9, dans le cadre de laquelle le profilé creux (41) peut être enfiché dans un logement (43) du support (42).

11. Cellule d'évaporation selon au moins l'une quelconque des revendications précédentes, dans le cadre de laquelle un dispositif de régulation (60) est prévu aux fins du réglage du dispositif de chauffage (20).

12. Cellule d'évaporation selon la revendication 11, dans le cadre de laquelle le dispositif de régulation (60) contient un premier circuit de régulation (61) servant à régler un mode de chauffage par résistance.

13. Cellule d'évaporation selon la revendication 11 ou 12, dans le cadre de laquelle le dispositif de régulation (60) contient un deuxième circuit de régulation (62) servant à régler un mode de chauffage par faisceau électronique.

14. Cellule d'évaporation selon au moins l'une quelconque des revendications 11 à 13, dans le cadre de laquelle le dispositif de régulation (60) est prévu aux fins du réglage simultané du mode de chauffage par résistance et du mode de chauffage par faisceau électronique.

15. Cellule d'évaporation selon au moins l'une quelconque des revendications 11 à 14, dans le cadre de laquelle le dispositif de mesure de température (30) est relié à au moins l'un des premier et deuxième circuits de régulation (61, 62).

16. Installation de revêtement, qui est équipée d'au moins une cellule d'évaporation selon au moins l'une quelconque des revendications précédentes.

17. Procédé d'évaporation d'un produit à évaporer présentant un point de fusion élevé à une température supérieure à 1900 °C, comprenant les étapes suivantes consistant à :
- mettre à disposition le produit à évaporer dans un creuset (10), et
- chauffer le creuset (10), sachant que dans ce cadre un chauffage par résistance du creuset (10) est effectué, dans une première plage de température, à l'aide d'une résistance chauffante (21) d'un dispositif de chauffage (20),
**caractérisé en ce que**
- lors du chauffage du creuset (10) dans une deuxième plage de température, un chauffage par faisceau électronique du creuset (10) est effectué à l'aide de la résistance chauffante (21).

18. Procédé selon la revendication 17, dans le cadre duquel la montée en température est prévue sur plusieurs côtés du creuset (10).

19. Procédé selon la revendication 17 ou 18, dans le cadre duquel on mesure une température de fonctionnement de la cellule d'évaporation (100).

20. Procédé selon la revendication 19, dans le cadre duquel la température de fonctionnement de la cellule d'évaporation (100) est mesurée dans l'environnement d'un fond de creuset (11) du creuset (10).

21. Procédé selon au moins l'une quelconque des revendications 17 à 20, comprenant l'étape suivante consistant à :
- régler le dispositif de chauffage (20) à l'aide d'un dispositif de régulation (60).

22. Procédé selon la revendication 21, dans le cadre duquel un mode de chauffage par résistance est prévu avec un premier circuit de régulation (61) dans la première phase de fonctionnement.

23. Procédé selon la revendication 21 ou 22, dans le cadre duquel un mode de chauffage par faisceau électronique est prévu avec un deuxième circuit de régulation (62) dans la deuxième phase de fonctionnement.

24. Procédé selon la revendication 22 ou 23, dans le cadre duquel un signal de température du capteur de température est amené à au moins un des premier et deuxième circuits de régulation (61, 62) en tant que grandeur de régulation.
